# EUROPEAN PATENT APPLICATION

(11) **EP 3 506 378 A1**
(43) Date of publication of application: **03.07.2019**
(21) Application number: 18849414.0
(22) Date of filing: 17.05.2018
(51) Int. Cl.: H01L 51/48

(54) **DEVICE FOR IMPROVING UNIFORMITY OF PEROVSKITE FILM FORMATION, AND METHOD THEREFOR**

(30) Priority: 22.09.2017 CN 201710862827
(71) Applicant: Hangzhou Microquanta Semiconductor Corporation Limited, Hangzhou, Zhejiang 311121 (CN)
(72) Inventor: PENG, Dehua, Hangzhou Zhejiang 311121 (CN); YAN, Buyi, Hangzhou Zhejiang 311121 (CN); YAO, Jizhong, Hangzhou Zhejiang 311121 (CN)
(74) Representative: Sun, Yiming
(86) International application number: PCT/CN2018/087358
(87) International publication number: WO 2019/056779

(57) **Abstract**

Provided is a device for improving perovskite film formation uniformity, including a grinder and a sheeter, wherein the grinder grinds a perovskite precursor into a powder, the sheeter presses the ground precursor powder into a precursor sheet, the sheeter includes a mold for pressing the precursor powder and a heating device, and the heating device heats a lower mold. A method of using the above device for improving perovskite film formation uniformity, and a method of preparing a perovskite solar cell are also provided. The precursor sheet prepared herein not only solves the problems of uneven particle size and uneven spreading at the bottom of the evaporation source or incomplete coverage, but also prevents splashing during vacuuming and aeration, and meanwhile, since the precursor powder is compacted, it is more conducive to the uniform conduction of heat during the heating and evaporation process, thereby improving the heat energy use efficiency.

## Description

### TECHNICAL FIELD

The present invention relates to the technical field of manufacturing of perovskite solar cells, in particular to a device and a method for improving perovskite film formation uniformity.

### BACKGROUND ART

In perovskite solar cells, the quality of a perovskite film directly affects the performance of the cell. At present, the methods of preparing perovskite films are mainly divided into two major categories: a solution method and a vapor phase method. The solution method is divided into a one-step solution method and a two-step solution method. Since the one-step solution method cannot control the crystallization process of the perovskite film, the uniformity and repeatability of the film are poor. The two-step solution method has higher requirements for operation technique and requires high material consumption during preparation, and therefore is not suitable for the production of large-sized components. The vapor phase method mainly includes: a dual source vapor evaporation deposition method, a chemical vapor deposition method, etc. The perovskite film prepared by the vapor phase method has good crystal quality, is uniform and compact, and can realize large-scale production, so it has great potential in the process of industrialization of perovskite, and has been widely used in the industrial production of other types of thin film solar cells, such as copper indium gallium selenide (CIGS), cadmium telluride (CdTe), gallium arsenide (GaAs).

In the process of preparing a perovskite film by vapor evaporation deposition, the uniformity of a particle size of an AX precursor and a tiling state at the bottom of the evaporation source are essential for the uniform crystallization of the perovskite film. If the particle size of the AX precursor is not uniform, or the surface is uneven after spreading at the bottom of the evaporation source, or the bottom is covered incompletely, it will affect the uniformity of AX evaporation, and thus affect the film formation quality of the perovskite film. For example, when the particle size of the AX precursor is not uniform, small particles are more likely to evaporate, while large particles evaporate more slowly, causing the AX vapor to exhibit an uneven rise state. Since the evaporation process is a heat conduction process after the AX is spread at the bottom of the evaporation source, heat is conducted from the bottom to the upper surface, so that the uppermost AX is first evaporated. At this time, if the AX spreads unevenly, some places are thick and some are thin. Thus, the heat conduction process will be different, the thin places are more likely to evaporate, resulting in uneven gas-solid reaction. The situation that the AX is spread at the bottom incompletely is similar.

On the other hand, in the operation of vapor evaporation deposition, during the initial vacuuming process and the aeration process after the deposition is completed, the gas in the evaporation chamber will have a large disturbance in the initial stage, which will easily cause the splash of AX precursor powder and affect the crystallization of the perovskite film.

The existing vapor evaporation deposition process needs to be further modified and improved.

### SUMMARY

To solve the above technical problems, the present invention is directed to a device and a method for improving perovskite film formation uniformity, and provides a method of preparing a sheet-like AX precursor. The present invention not only solves the problems of uneven particle size and uneven spreading at the bottom of the evaporation source or incomplete coverage, but also prevents generating splashing during vacuuming and aeration, and meanwhile, since the AX precursor powder is compacted, which facilitates the uniform conduction of heat during the heating and evaporation process, thereby improving the heat energy use efficiency.

The present invention is achieved by providing a device for improving perovskite film formation uniformity, including a grinder and a sheeter, wherein the grinder grinds a perovskite precursor into powder, the sheeter presses the ground precursor powder into a precursor sheet, the sheeter includes a mold for pressing the precursor powder and a heating device, and the heating device heats a lower mold.

Further, the sheeter is a manual sheeter, the manual sheeter includes a base, a mold base, columns, an upper plate, a hand wheel, a screw rod, a handle lever and a power source, a oil hydraulic system is disposed in the base, the heating device is disposed in the mold base, the mold base is disposed at a middle portion of the base, the mold is disposed on the mold base, the upper plate is disposed on the top of the two columns, the hand wheel drives the screw rod to rotate, the screw rod is pressed down onto the mold, the handle lever adjusts the pressure of the oil hydraulic system, and the power source supplies power to the heating device.

Further, the perovskite precursor includes at least one of methylammonium halide (MAX), formamidine halide (FAX), ethylammonium halide (EAX), cesium halide (CsX) and rubidium halide (RbX), wherein the halide (X) is any one of CI, Br and I.

Further, the powder of the perovskite precursor after being ground has a particle size of 0.1-100 µm.

Further, the temperature of the heating device is controlled at 100-250°C, and the pressure of the sheeter is between 1-30 MPa.

Further, the precursor sheet has a thickness of 0.2-30 mm.

The present invention is achieved by further providing a method of using the above device for improving perovskite film formation uniformity, including the following steps:
1) firstly grinding one or more precursors by a grinder to obtain a precursor powder having a uniform particle size of 0.1-100 µm; and
2) then transferring the ground precursor powder into the mold, and pressing the precursor powder into a sheet by the sheeter to prepare a precursor sheet.

Further, the grinder is a planetary ball mill, the planetary ball mill has a revolution speed of 50-400 rpm and a rotation speed of 100-800 rpm, the ball milling time is in the range of 1-720 min, and the precursor is ground to obtain a precursor powder having a uniform particle size of 0.1-100 µm.

Further, the sheeter is a manual sheeter, the manual sheeter includes a base, a mold base, columns, an upper plate, a hand wheel, a screw rod, a handle lever and a power source, an oil hydraulic system is disposed in the base, the heating device is disposed in the mold base, the mold base is disposed at a middle portion of the base, the mold is disposed on the mold base, the upper plate is disposed on the top of the two columns, the hand wheel drives the screw rod to rotate, the screw rod is pressed down onto the mold, the handle lever adjusts the pressure of the oil hydraulic system, and the power source supplies power to the heating device; and the temperature of the heating device is controlled at 100-250°C, the ball-milled precursor powder is added into the mold and heated for 0-30 min along with the mold, the hand wheel is rotated to tighten the screw rod to fix the mold, the handle lever is shaken to pressurize the mold under the pressure of 1-30 MPa, and after the sheet pressing is completed, the pressed precursor sheet in the mold is taken out.

The present invention is achieved by further providing a method of preparing a perovskite solar cell, including the following steps: preparing a metal halide film on a substrate in advance, transferring the substrate into an evaporation chamber for vacuuming, and heating and evaporating the precursor sheet placed in advance such that the precursor in the precursor sheet carries out a gas-solid reaction with the metal halide film in a vapor form to form a compact and uniform perovskite film, wherein the precursor sheet is prepared by using the above device for improving perovskite film formation uniformity, or by using the above method of using the device for improving perovskite film formation uniformity.

Compared with the prior art, according to the device and method for improving perovskite film formation uniformity in the present invention, the perovskite precursor is ground into a powder by a grinder, and the ground precursor powder is pressed into a precursor sheet by a sheeter. The prepared sheet-like precursor not only well solves the problems of uneven particle size and uneven spreading at the bottom of the evaporation source or incomplete coverage, but also prevents splashing during vacuuming and aeration, and meanwhile, the precursor powder is compacted, which facilitates the uniform conduction of heat during the heating and evaporation process, thereby improving the heat energy use efficiency.

### BRIEF DESCRIPTION OF THE DRAWING

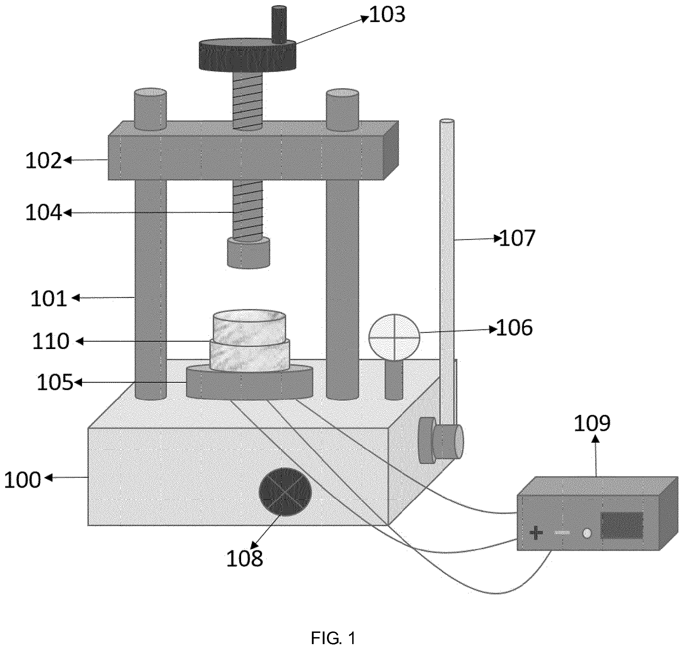

FIG. 1 is a perspective view of a preferred embodiment of a manual sheeter according to an example of the present invention.

### DETAILED DESCRIPTION

In order to make the technical problems to be solved, technical solutions and advantageous effects of the present invention clearer, the present invention will be described in detail below with reference to the accompanying drawing and embodiments. It should be understood that the specific embodiments described herein are merely illustrative of the present invention and are not intended to limit the present invention.

The vapor evaporation deposition method is a method for preparing a perovskite film used more frequently at present. In this method, the substrate is transferred into the evaporation chamber for vacuuming, and the AX and BX2 placed in advance are heated and evaporated such that the AX reacts with the BX2 to generate a compact and uniform perovskite film. Related work reported did not perform related processing on the AX precursor in the evaporation source, which can not guarantee the uniformity of the particle size of the AX precursor, and also easily causes the problems of uneven spreading at the bottom of the evaporation source, incomplete coverage, etc. In addition, during the vacuuming and aeration process, the gas in the evaporation chamber will have a large disturbance in the initial stage, easily causing the splash of the AX precursor powder. These problems will affect the uniformity of AX evaporation, which in turn affects the film formation quality of the perovskite film.

The present invention provides an improved solution to the existing vapor assisted deposition method.

FIG.1 shows a preferred embodiment of a device and method for improving perovskite film formation uniformity, including a grinder (not shown) and a sheeter. The grinder grinds one or more perovskite precursors into a powder. The sheeter presses the ground precursor powder into a precursor sheet.

In this embodiment, the sheeter is a manual sheeter. The sheeter includes a mold 110 for pressing a precursor powder and a heating device (not shown), and further includes a base 100, a mold base 105, columns 101, an upper plate 102, a hand wheel 103, a screw rod 104, and a handle lever 107, a power source 109, an oil drain valve 108 and a pressure gauge 106. The heating device heats the mold. An oil hydraulic system is disposed in the base 100, and the heating device is disposed in the mold base 105. The mold base 105 is disposed at a middle portion of the base 100. The mold 110 is disposed on the mold base 105, and the upper plate 102 is disposed on the top of the two columns 101. The hand wheel 103 drives the screw rod 104 to rotate, and the screw rod 104 is pressed down onto the mold 110 to compress the mold 110. The handle lever 107 is used to adjust the pressure of the oil hydraulic system. The power source 109 supplies power to the heating device to supply current to a resistance wire in the mold base 105, causing the wire to heat up, and the power source is connected to a thermocouple to convert the temperature of the mold base 105 into a digital signal for display on a display screen. The oil drain valve 108 is used to relieve the pressure of the oil hydraulic system, and the pressure gauge 106 displays the real-time pressure of the oil hydraulic system.

The perovskite precursor includes at least one of methylammonium halide (MAX), formamidine halide (FAX), ethylammonium halide (EAX), cesium halide (CsX) and rubidium halide (RbX), wherein the halide (X) is any one of Cl, Br and I.

In this embodiment, the powder of the perovskite precursor after being ground has a particle size of 0.1-100 µm. The temperature of the heating device is controlled at 100-250°C, and the pressure of the sheeter is between 1-30 MPa. The precursor sheet has a thickness of 0.2-30 mm.

The present invention further discloses a method of using the above device for improving perovskite film formation uniformity, including the following steps:
1) Firstly one or more precursors is ground by a grinder to obtain a precursor powder having a uniform particle size of 0.1-100 µm. A plurality of precursors are ground by a grinder to achieve uniform mixing, and are suitable for use in a vapor phase method for preparing a mixed perovskite film.
2) Then the ground precursor powder is transferred into the mold, and the precursor powder is pressed into a sheet by the sheeter to prepare a precursor sheet. The precursor will be made into the precursor sheet, which solves many disadvantages of powder spreading and can realize mass production. The sheets can be used as needed and therefore meet the needs for industrial production.

In this embodiment, the grinder is a planetary ball mill, the planetary ball mill has a revolution speed of 50-400 rpm and a rotation speed of 100-800 rpm, the ball milling time is in the range of 1-720 min, and the precursor is ground to obtain a precursor powder having a uniform particle size of 0.1-100 µm.

In this embodiment, the sheeter is a manual sheeter, and the manual sheeter includes a base, a mold base, columns, an upper plate, a hand wheel, a screw rod, a handle lever and a power source. An oil hydraulic system is disposed in the base, the heating device is disposed in the mold base, the mold base is disposed at a middle portion of the base, the mold is disposed on the mold base, the upper plate is disposed on the top of the two columns, the hand wheel drives the screw rod to rotate, and the screw rod is pressed down onto the mold. The handle lever adjusts the pressure of the oil hydraulic system, and the power source supplies power to the heating device.

The temperature of the heating device is controlled at 100-250°C, and the ball-milled precursor powder is added into the mold and heated for 0-30 min along with the mold. The hand wheel is rotated to tighten the screw rod to fix the mold, the handle lever is then shaken to pressurize the mold under the pressure of 1-30 MPa. After the sheet pressing is completed, the pressed precursor sheet in the mold is taken out.

The size of the precursor sheet is identical to the internal dimensions of the evaporation source, so that the pressed precursor sheet can be placed flatly and covered completely on the bottom of the evaporation source. The precursor sheet is similar to a compressed biscuit and can be mass-produced. The precursor sheet is stored in a dry environment for storage, and can be used as needed before each preparation of the perovskite film.

In order to further explain the present invention in detail, further explanation will be given by way of examples in conjunction with the accompanying drawing. It should be noted that the specific process parameters of the following examples are only one example of a suitable range, and do not impose additional limitations on the protection scope of the present invention.
1) Particles of two halides MAI and FAI are taken, and added to a ball mill tank of the planetary ball mill for ball milling according to the mass ratio of 3:7, the ball mill having a revolution speed of 300 rpm and a rotation speed of 600 rpm, and the ball milling time being 2 hours, thereby obtaining two AX precursor powders having uniform particle size.
2) The customized mold 110 is placed at the center of the mold base 105 of the sheeter and heated by the power source 109, the temperature is set to 120°C, then the ball-milled MAI and FAI mixed powder is added to the mold 110, the mold 110 is shaken such that the powder is filled uniformly, and the powder is heated for 10 min along with the mold.
3) Before the sheet pressing, the oil drain valve 108 is tightened, the hand wheel 103 is rotated to tighten the screw rod 104 to fix the mold 110, then the handle lever 107 is rocked back and forth to pressurize the mold until pressure reaches 15 MPa and thus the sheet pressing is completed.
4) At this time, the oil drain valve 108 is firstly opened to release the pressure, the power source 109 is turned off at the same time, the screw rod 104 is loosened, and the MAI and FAI mixed powder precursor sheet in the mold 110 is taken out.

The present invention further discloses a method of preparing a perovskite solar cell, including the following steps: a metal halide film is prepared on a substrate in advance, transferred into an evaporation chamber for vacuuming, and the precursor sheet placed in advance is heated and evaporated such that the precursor in the precursor sheet carries out a gas-solid reaction with the metal halide film in a vapor form to form a compact and uniform perovskite film, where the precursor sheet is prepared by using the above device for improving perovskite film formation uniformity, or by using the above method of using the device for improving perovskite film formation uniformity.

The perovskite film prepared by using this sheet-like AX precursor has a smooth surface and good crystallization, and is compact and uniform.

The above description is only the preferred embodiments of the present invention and is not intended to limit the present invention. Any modifications, equivalent substitutions and improvements made within the spirit and scope of the present invention should be included within the protection scope of the present invention.

## Claims

1. A device for improving perovskite film formation uniformity, comprising a grinder and a sheeter, wherein the grinder grinds a perovskite precursor into a powder, the sheeter presses the ground precursor powder into a precursor sheet, the sheeter comprises a mold for pressing the precursor powder and a heating device, and the heating device heats a mold.

2. The device for improving perovskite film formation uniformity according to claim 1, wherein the sheeter is a manual sheeter, the manual sheeter comprises a base, a mold base, columns, an upper plate, a hand wheel, a screw rod, a handle lever and a power source, an oil hydraulic system is disposed in the base, the heating device is disposed in the mold base, the mold base is disposed at a middle portion of the base, the mold is disposed on the mold base, the upper plate is disposed on the top of the two columns, the hand wheel drives the screw rod to rotate, the screw rod is pressed down onto the mold, the handle lever adjusts the pressure of the oil hydraulic system, and the power source supplies power to the heating device.

3. The device for improving perovskite film formation uniformity according to claim 1, wherein the perovskite precursor comprises at least one of methylammonium halide, formamidine halide, ethylammonium halide, cesium halide and rubidium halide, and the halide is any one of Cl, Br and I.

4. The device for improving perovskite film formation uniformity according to claim 1, wherein the powder of the perovskite precursor after being ground has a particle size of 0.1-100 µm.

5. The device for improving perovskite film formation uniformity according to claim 1, wherein the temperature of the heating device is controlled at 100-250°C, and the pressure of the sheeter is between 1-30 MPa.

6. The deviceor improving perovskite film formation uniformity according to claim 1, wherein the precursor sheet has a thickness of 0.2-30 mm.

7. A method of using the device for improving perovskite film formation uniformity according to any of claims 1 to 6, comprising the following steps:
1) firstly grinding one or more precursors by a grinder to obtain a precursor powder having a particle size of 0.1-100 µm; and
2) then transferring the ground precursor powder into the mold, and pressing the precursor powder into a sheet by the sheeter to prepare a precursor sheet.

8. The method of using the device for improving perovskite film formation uniformity according to claim 7, wherein the grinder is a planetary ball mill, the planetary ball mill has a revolution speed of 50-400 rpm and a rotation speed of 100-800 rpm, the ball milling time is in the range of 1-720 min, and the precursor is ground to obtain a precursor powder having a particle size of 0.1-100 µm.

9. The method of using the device for improving perovskite film formation uniformity according to claim 7, wherein the sheeter is a manual sheeter, the manual sheeter comprises a base, a mold base, columns, an upper plate, a hand wheel, a screw rod, a handle lever and a power source, an oil hydraulic system is disposed in the base, the heating device is disposed in the mold base, the mold base is disposed at a middle portion of the base, the mold is disposed on the mold base, the upper plate is disposed on the top of the two columns, the hand wheel drives the screw rod to rotate, the screw rod is pressed down onto the mold, the handle lever adjusts the pressure of the oil hydraulic system, and the power source supplies power to the heating device; and the temperature of the heating device is controlled at 100-250°C, the ball-milled precursor powder is added into the mold and heated for 0-30 min along with the mold, the hand wheel is rotated to tighten the screw rod to fix the mold, the handle lever is then shaken to pressurize the mold under the pressure of 1-30 MPa, and after the sheet pressing is completed, the pressed precursor sheet in the mold is taken out.

10. A method of preparing a perovskite solar cell, comprising the following steps: preparing a metal halide film on a substrate in advance, transferring into an evaporation chamber for vacuuming, and heating and evaporating the precursor sheet placed in advance such that the precursor in the precursor sheet carries out a gas-solid reaction with the metal halide film in a vapor form to form a compact and uniform perovskite film, wherein the precursor sheet is prepared by using the device for improving perovskite film formation uniformity according to any of claims 1 to 6, or by using the method of using the device for improving perovskite film formation uniformity according to any of claims 7 to 9.
